# EUROPÄISCHE PATENTSCHRIFT

(11) **EP 4 392 281 B1**
(45) Veröffentlichungstag und Bekanntmachung des Hinweises auf die Patenterteilung: **23.09.2026**
(21) Anmeldenummer: 22760723.1
(22) Anmeldetag: 02.08.2022
(51) Int. Cl.: B60K 35/10, B60K 35/22, B60K 35/80, H03K 17/955, H03K 17/96

(54) **BEDIENVORRICHTUNG FÜR EIN KRAFTFAHRZEUG**
CONTROL DEVICE FOR A MOTOR VEHICLE
DISPOSITIF DE COMMANDE POUR UN VÉHICULE AUTOMOBILE

(30) Priorität: 25.08.2021 DE 102021121955
(43) Veröffentlichungstag der Anmeldung: 03.07.2024
(73) Patentinhaber: Bayerische Motoren Werke Aktiengesellschaft, 80809 München (DE)
(72) Erfinder: LINDNER, Matthias, 82166 Gräfelfing (DE)
(86) Internationale Anmeldenummer: PCT/EP2022/071687
(87) Internationale Veröffentlichungsnummer: WO 2023/025538

(56) Entgegenhaltungen:
- WO-A1-2020/148060
- DE-A1- 102018 009 543
- US-A1- 2016 288 462
- US-B1- 9 092 136

## Beschreibung

Die vorliegende Erfindung betrifft eine Bedienvorrichtung für ein Kraftfahrzeug mit den Merkmalen des Oberbegriffs des Patentanspruchs 1.

Aus dem Stand der Technik sind verschiedene Bedienvorrichtungen für Kraftfahrzeuge bekannt.

Die DE 10 2008 060 363 A1 offenbart ein Bediensystem zum Bedienen von Funktionen in einem Kraftfahrzeug. Das Bediensystem umfasst eine optische Projektionseinrichtung zur graphischen Wiedergabe virtueller Bedienelemente auf einer zugeordneten Darstellungsfläche einer Fahrzeuginnenraumverkleidung und eine Erfassungseinrichtung. Die Erfassungseinrichtung weist eine druckempfindliche Folie auf, die Bedieneingaben bei einer Betätigung der virtuellen Bedienelemente erfasst.

Um den Fahrzeuginnenraum ansprechend zu gestalten, ist die Fahrzeuginnenraumverkleidung oder ein Teil dieser regelmäßig aus einem weichen Material wie Stoff, Leder und/oder einem Lederimitat gebildet. Diese Materiale dämpfen jedoch den bei einer Betätigung auf das virtuelle Bedienelement ausgeübten Druck so stark, dass die Betätigung mittels der aus der DE 10 2008 060 363 A1 bekannten druckempfindlichen Folie nicht mehr erfassbar ist.

Die DE 10 2019 002 884 A1 beschreibt eine Bedienvorrichtung, die eine Projektionseinrichtung, eine Detektionseinrichtung, eine Auswerteeinrichtung und ein Anzeigeelement umfasst. Mittels der Projektionseinrichtung ist ein Bedienelement durch sichtbare Lichtstrahlen als Bild auf das Anzeigeelement projizierbar, so dass auf das Bedienelement durch einen Nutzer eingewirkt werden kann. Die Detektionseinrichtung detektiert die Einwirkung des Nutzers auf das Bedienelement. Die Bedienvorrichtung umfasst wenigstens eine Infrarot-Quelle zur Projektion von Infrarot-Strahlung auf das Anzeigeelement. Die Detektionseinrichtung weist einen Infrarot-Empfänger auf. Der Infrarot-Empfänger empfängt die vom Anzeigeelement und/oder von dem Nutzer reflektierte Infrarot-Strahlung, der auf das Bedienelement einwirkt.

Die Infrarot-Quelle und der Infrarot-Empfänger sind also derart im Innenraum eines Kraftfahrzeugs zu positionieren, dass diese korrespondierend zum Bedienelement auf das Anzeigeelement gerichtet sind. Aufgrund der Anordnung der Infrarot-Quelle und des Infrarot-Empfängers im Innenraum des Kraftfahrzeugs sind diese einem hohen Beschädigungsrisiko ausgesetzt. Hierdurch ist die Betriebssicherheit des aus der DE 10 2019 002 884 A1 bekannten Bedienvorrichtung gering. Zudem erfordern die Infrarot-Quelle und der Infrarot-Empfänger viel Bauraum im Innenraum des Kraftfahrzeugs. Ferner ist die in der DE 10 2019 002 884 A1 beschriebene Detektionseinrichtung fehleranfällig, da der Infrarot-Empfänger tagsüber auch dem Infrarotanteil des Sonnenlichts detektiert und somit das Messergebnis von Umgebungsbedingungen beeinflusst ist.

Aus der US 2016/288462 A1 ist eine Bedienvorrichtung gemäß dem Oberbegriff von Anspruch 1 bekannt.

Ferner ist aus der WO 2020/148060 A1 ein Bediensystem mit portabler Schnittstelleneinheit sowie ein Kraftfahrzeug mit solch einem Bediensystem bekannt.

Die US 9 092 136 B1 beschreibt ein Anzeigesystem mit einem projizierten Bedienelement.

Außerdem ist aus der DE 10 2018 009543 A1 eine auf eine Anzeigefläche projizierte Bedienvorrichtung bekannt.

Es ist eine Aufgabe der vorliegenden Erfindung, eine Bedienvorrichtung bereitzustellen, welche eine hohe Betriebssicherheit aufweist und wenig Bauraum erfordert.

Diese Aufgabe ist durch die Bedienvorrichtung mit den Merkmalen des Patentanspruchs 1 gelöst.

Erfindungsgemäß wird also eine Bedienvorrichtung für ein Kraftfahrzeug bereitgestellt, umfassend ein Anzeigeelement, eine Projektionseinrichtung und einen kapazitiven Näherungssensor. Mittels der Projektionseinrichtung ist mindestens ein Bedienelement auf eine Sichtfläche des Anzeigeelements projizierbar. Mittels des kapazitiven Näherungssensors ist eine Betätigung des Bedienelements, insbesondere eine Berührung des Bedienelements und/oder eine Annäherung an das Bedienelement detektierbar.

Es wird also eine Bedienvorrichtung bereitgestellt, bei welcher das Bedienelement auf das Anzeigeelement projiziert ist. Eine Betätigung des Bedienelements ist mittels des kapazitiven Sensors erfassbar, welcher einen geringen Bauraumbedarf aufweist.

Der kapazitive Sensor ist an dem Anzeigeelement, insbesondere auf einer der Sichtfläche, d.h. einer einem Fahrzeuginsassen abgewandten Seite des Anzeigeelements angeordnet. Da der kapazitive Sensor nicht in einen Innenraum des Kraftfahrzeugs hineinragt, ist eine Beschädigungswahrscheinlichkeit des kapazitiven Sensors gering. Mithin weist die erfindungsgemäße Bedienvorrichtung eine hohe Bediensicherheit auf.

Bei einer bevorzugten Ausführungsform der Bedienvorrichtung nach der Erfindung ist das Anzeigeelement nichtleitend, d.h. es ist aus einem keine Elektrizität leitenden Material gebildet.

Das Anzeigeelement kann aus einem weichen Material gebildet sein. Somit ist eine Veränderung der Form des Anzeigeelements mit geringem Kraftaufwand möglich.

Das Anzeigeelement ist beispielsweise aus einem intransparenten Material. Eine Durchleuchtung des Anzeigeelements ist mithin nicht möglich.

Bei einer beispielhaften Ausführungsform der Bedienvorrichtung nach der Erfindung ist das Anzeigeelement ein Textil, ein Leder und/oder ein Lederimitat.

Der kapazitive Näherungssensor kann an dem Anzeigeelement angeordnet sein.

Der kapazitive Näherungssensor ist beispielsweise an einer der Sichtfläche gegenüberliegenden Seite des Anzeigeelements angeordnet.

Zwischen dem Anzeigeelement und dem kapazitive Näherungssensor kann ein Nichtleiter, d.h. ein Zwischenelement aus einem nichtleitenden Material, insbesondere aus einem Schaum angeordnet sein.

Bei einer beispielhaften Ausführungsform umfasst die Bedienvorrichtung nach der Erfindung eine Abschirmeinrichtung zur gezielten Beeinflussung eines Wirkbereichs des kapazitiven Näherungssensors. Die Abschirmeinrichtung gibt dem von dem kapazitiven Näherungssensor ausgehenden elektrischen Feld eine gewünschte Ausdehnung und Richtung vor. Somit wird gewährleistet, dass der kapazitive Näherungssensor nur in einem definierten Betätigungsbereich eine Betätigung des Bedienelements detektiert.

Nach der Erfindung umfasst die Projektionseinrichtung eine Lichtquelle zur Erzeugung sichtbarer Lichtstrahlen, eine Vielzahl von Linsen zum Einfangen und zur Parallelisierung der Lichtstrahlen, ein zu projizierendes Projektionsobjekt und eine Reflexionsfläche. Mittels der Reflexionsfläche sind die Lichtstrahlen derart an die Sichtfläche projizierbar, dass das Projektionsobjekt in Form des Bedienelements sichtbar ist.

Die Lichtquelle ist beispielsweise eine Leuchtdiode.

Die Reflexionsfläche kann verspiegelt sein.

Bei der Bedienvorrichtung nach der Erfindung sind die Lichtquelle, die Vielzahl von Linsen und das Projektionsobjekt auf einer der Lichtfläche abgewandten Seite des Anzeigeelements angeordnet. Die Reflexionsfläche ist auf der Seite der Sichtfläche angeordnet, so dass diese die von der Lichtquelle erzeugten Lichtstrahlen auf die Sichtfläche des Anzeigeelements als Bedienelement projizieren kann.

Das Projektionsobjekt ist zwischen den Linsen der Vielzahl von Linsen angeordnet.

Bei einer bevorzugten Ausführungsform der Bedienvorrichtung nach der Erfindung ist die Reflexionsfläche an einer weiteren Bedienvorrichtung angeordnet.

Die weitere Bedienvorrichtung kann dreidimensional ausgebildet sein und kann an der Seite der Sichtfläche angeordnet sein.

Die weitere Bedienvorrichtung ist beispielsweise ein Sitzverstellschalter.

Bei einer beispielhaften Ausführungsform umfasst die Bedienvorrichtung nach der Erfindung eine Auswerteeinrichtung. Mittels der Auswerteeinrichtung ist ein mit der detektierten Betätigung korrespondierendes Signal, insbesondere in der Art eines Schaltsignals zum Bedienen und/oder Auslösen einer Funktion des Kraftfahrzeugs erzeugbar.

Die Funktion des Kraftfahrzeugs kann eine Sitzverstellung sein.

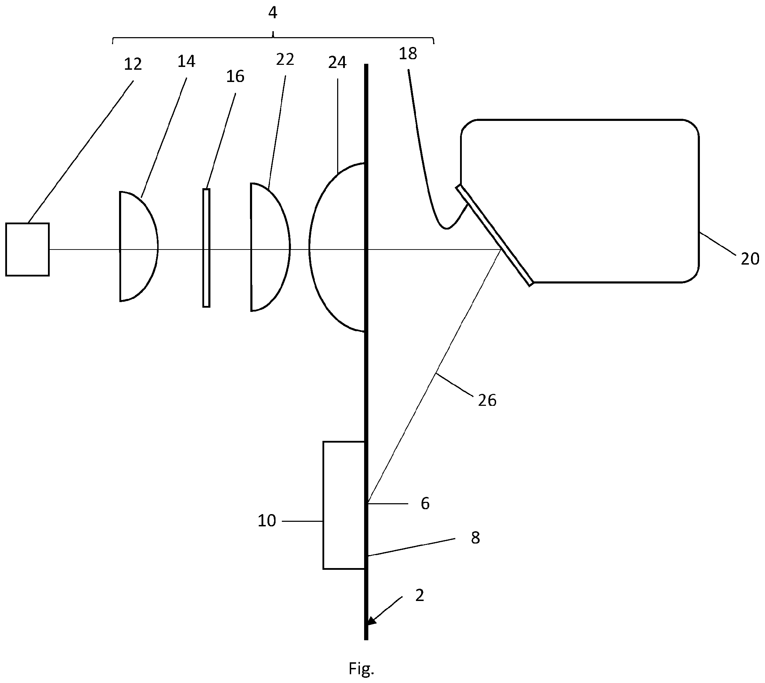

Die Erfindung ist im Folgenden anhand eines in der Zeichnung dargestellten Ausführungsbeispiels näher erläutert. Es zeigt:
- **Fig.**: eine Seitenansicht einer Bedienvorrichtung für ein Kraftfahrzeug nach der Erfindung.

In der **Figur** ist eine Bedienvorrichtung für ein Kraftfahrzeug nach der Erfindung dargestellt.

Die Bedienvorrichtung umfasst ein Anzeigeelement 2 mit einer Sichtfläche 8, die einem Fahrzeuginsassen zugewandt ist, eine Projektionseinrichtung 4 und einen kapazitiven Näherungssensor 10. Mittels der Projektionseinrichtung 4 ist mindestens ein Bedienelement 6 auf die Sichtfläche 8 des Anzeigeelements 2 projizierbar. Eine Bedienung des Bedienelements 6 durch einen Fahrzeuginsassen ist mittels des kapazitiven Näherungssensors 10 erfassbar, der auf einer der Sichtfläche 8, also dem Fahrzeuginsassen abgewandten Seite des Anzeigeelements 2 angeordnet ist.

Das Anzeigeelement 2 ist aus einem weichen Material, das heißt es ist so beschaffen, dass ein Verändern dessen Form mit geringem Kraftaufwand möglich ist. Das weiche Material ist nichtleitend. Das Anzeigeelement 2 bildet eine Türinnenverkleidung.

Die Projektionseinrichtung 4 umfasst eine Lichtquelle 12 in Form einer Leuchtdiode, eine erste Linse 14 zum Einfangen der Lichtstrahlen 26 der Lichtquelle 12, ein zu projizierendes Projektionsobjekt 16, eine zweite Linse 22 und eine dritte Linse 24 zur Parallelisierung der Lichtstrahlen 26 sowie eine spiegelnde Reflexionsfläche 18.

Die Lichtquelle 12, die erste Linse 14, das Projektionsobjekt 16, die zweite Linse 22 und die dritte Linse 24 sind in der vorgenannten Reihenfolge auf einer der Sichtfläche 8 abgewandten Seite des Anzeigeelements 2 angeordnet, wobei die Lichtquelle 12 von dem Anzeigeelement 2 am weitesten entfernt ist.

Die Reflexionsfläche 18 ist an einem weiteren Bedienelement 26 angeordnet. Das weitere Bedienelement 26 ist ein dreidimensionaler Sitzverstellschalter.

Der kapazitive Näherungssensor 10 ist an der dem Fahrzeuginsassen nicht sichtbaren Seite des Anzeigeelements 2 angeordnet, so dass der kapazitive Näherungssensor 10 eine Berührung des projizierten Bedienelements 6 oder eine Annäherung an das projizierte Bedienelement 6 durch den Fahrzeuginsassen detektieren kann.

Detektiert der kapazitive Näherungssensor 10 eine Berührung des Bedienelements 6 und/ oder eine Annäherung an das Bedienelement 6, erzeugt eine (nicht dargestellte) Auswerteeinrichtung ein mit der detektierten Betätigung korrespondierendes Signal in der Art eines Schaltsignals zum Bedienen einer Funktion des Kraftfahrzeugs.

### Bezugszeichenliste:

- 2: Anzeigeelement
- 4: Projektionseinrichtung
- 6: Bedienelement
- 8: Sichtfläche
- 10: kapazitiver Näherungssensor
- 12: Lichtquelle
- 14: erste Linse
- 16: Projektionsobjekt
- 18: Reflexionsfläche
- 20: dreidimensionale Bedienvorrichtung
- 22: zweite Linse
- 24: dritte Linse
- 26: Lichtstrahl

## Patentansprüche

1. Bedienvorrichtung für ein Kraftfahrzeug, umfassend
ein Anzeigeelement (2);
eine Projektionseinrichtung (4), mittels der mindestens ein Bedienelement (6) auf eine Sichtfläche (8) des Anzeigeelements (2) projizierbar ist, und
einen kapazitiven Näherungssensor (10), mittels dem eine Betätigung des Bedienelements (6) detektierbar ist,
**dadurch gekennzeichnet, dass**
die Projektionseinrichtung (4) eine Lichtquelle (12) zur Erzeugung von Lichtstrahlen (26), eine Vielzahl von Linsen (14, 22, 24) zum Einfangen und zum Parallelisieren der Lichtstrahlen (26), ein zu projizierendes Projektionsobjekt (16) und eine Reflexionsfläche (18) umfasst, mittels der die Lichtstrahlen (26) als Bedienelement (6) an die Sichtfläche (8) projizierbar sind, und
die Lichtquelle (12), die Vielzahl von Linsen (14, 22, 24) und das Projektionsobjekt (16) auf einer der Sichtfläche (8) gegenüberliegenden Seite des Anzeigeelements (2) angeordnet sind und die Reflexionsfläche (18) auf der Seite der Sichtfläche (8) angeordnet ist.

2. Bedienvorrichtung nach Anspruch 1, wobei das Anzeigeelement (2) nichtleitend ist.

3. Bedienvorrichtung nach Anspruch 1 oder 2, wobei das Anzeigeelement (2) ein Textil, ein Leder und/oder ein Lederimitat ist.

4. Bedienvorrichtung nach einem der Ansprüche 1 bis 3, wobei der kapazitive Näherungssensor (10) an einer der Sichtfläche (8) gegenüberliegenden Seite des Anzeigeelements (2) angeordnet ist.

5. Bedienvorrichtung nach einem der Ansprüche 1 bis 4, ferner aufweisend eine Abschirmeinrichtung zur gezielten Beeinflussung eines Wirkbereichs des kapazitiven Näherungssensors (10).

6. Bedienvorrichtung nach einem der vorhergehenden Ansprüche, wobei die Reflexionsfläche (18) an einer dreidimensionalen Bedienvorrichtung (20) anordbar ist.

7. Bedienvorrichtung nach einem der Ansprüche 1 bis 6, ferner aufweisend eine Auswerteeinrichtung, mittels welcher ein mit der detektierten Betätigung korrespondierendes Schaltsignal zum Bedienen und/oder Auslösen einer Funktion erzeugbar ist.

## Claims

1. Operating device for a motor vehicle, comprising a display element (2);
a projection device (4), by means of which at least one operating element (6) can be projected onto a viewing surface (8) of the display element (2), and
a capacitive proximity sensor (10), by means of which an actuation of the operating element (6) can be detected,
**characterized in that**
the projection device (4) comprises a light source (12) for generating light beams (26), a plurality of lenses (14, 22, 24) for capturing and parallelizing the light beams (26), a projection object (16) to be projected and a reflection surface (18), by means of which the light beams (26) can be projected as operating element (6) onto the viewing surface (8), and
the light source (12), the plurality of lenses (14, 22, 24) and the projection object (16) are arranged on a side of the display element (2) opposite the viewing surface (8) and the reflection surface (18) is arranged on the side of the viewing surface (8).

2. Operating device according to claim 1, wherein the display element (2) is non-conductive.

3. Operating device according to claim 1 or 2, wherein the display element (2) is a textile, a leather and/or a leather imitation.

4. Operating device according to one of claims 1 to 3, wherein the capacitive proximity sensor (10) is arranged on a side of the display element (2) opposite the viewing surface (8).

5. Operating device according to one of claims 1 to 4, further comprising a shielding device for targeted influencing of an effective range of the capacitive proximity sensor (10).

6. Operating device according to one of the preceding claims, wherein the reflection surface (18) can be arranged on a three-dimensional operating device (20).

7. Operating device according to one of claims 1 to 6, further comprising an evaluation device, by means of which a switching signal corresponding to the detected actuation can be generated for operating and/or triggering a function.

## Revendications

1. Dispositif de commande pour un véhicule automobile, comprenant un élément d'affichage (2);
un dispositif de projection (4), au moyen duquel au moins un élément de commande (6) peut être projeté sur une surface de visualisation (8) de l'élément d'affichage (2), et
un capteur de proximité capacitif (10), au moyen duquel un actionnement de l'élément de commande (6) peut être détecté,
**caractérisé en ce que**
le dispositif de projection (4) comprend une source de lumière (12) pour générer des rayons lumineux (26), une pluralité de lentilles (14, 22, 24) pour capter et paralléliser les rayons lumineux (26), un objet de projection (16) à projeter et une surface de réflexion (18), au moyen de laquelle les rayons lumineux (26) peuvent être projetés en tant qu'élément de commande (6) sur la surface de visualisation (8), et
la source de lumière (12), la pluralité de lentilles (14, 22, 24) et l'objet de projection (16) sont disposés sur un côté de l'élément d'affichage (2) opposé à la surface de visualisation (8) et la surface de réflexion (18) est disposée du côté de la surface de visualisation (8).

2. Dispositif de commande selon la revendication 1, dans lequel l'élément d'affichage (2) est non conducteur.

3. Dispositif de commande selon la revendication 1 ou 2, dans lequel l'élément d'affichage (2) est un textile, un cuir et/ou une imitation de cuir.

4. Dispositif de commande selon l'une des revendications 1 à 3, dans lequel le capteur de proximité capacitif (10) est disposé sur un côté de l'élément d'affichage (2) opposé à la surface de visualisation (8).

5. Dispositif de commande selon l'une des revendications 1 à 4, comprenant en outre un dispositif de blindage pour influencer de manière ciblée une zone d'action du capteur de proximité capacitif (10).

6. Dispositif de commande selon l'une des revendications précédentes, dans lequel la surface de réflexion (18) peut être disposée sur un dispositif de commande tridimensionnel (20).

7. Dispositif de commande selon l'une des revendications 1 à 6, comprenant en outre un dispositif d'évaluation, au moyen duquel un signal de commutation correspondant à l'actionnement détecté peut être généré pour commander et/ou déclencher une fonction.
